# EUROPEAN PATENT APPLICATION

(11) **EP 4 746 383 A1**
(43) Date of publication of application: **20.05.2026**
(21) Application number: 25214864.8
(22) Date of filing: 11.11.2025
(51) Int. Cl.: H04L 67/12, H04L 67/62, H04W 4/38

(54) **MULTI-GATEWAY COORDINATION IN THERMAL MANAGEMENT SYSTEMS**

(30) Priority: 15.11.2024 US 202463721092 P; 03.11.2025 US 202519377579
(71) Applicant: Vertiv Corporation, Westerville, OH 43082 (US)
(72) Inventor: Keller, Matthew Griffith, Westerville, 43082 (US); Spatz, Mark Andrew, Westerville, 43082 (US); Voigt, Tyler William, Westerville, 43082 (US)
(74) Representative: Cousens, Nico

(57) **Abstract**

A system and method for coordinating gateway polling in a multi-gateway sensor system, for instance a sensor system implemented in a data center for monitoring thermal conditions. The system includes at least two subsets of sensors in communication with at least two gateways, and a controller in communication with the at least two gateways configured to implement a dynamic polling scheme to coordinate polling of the at least two gateways. In embodiments, the dynamic polling scheme includes scheduling nonoverlapping timeslots at which to poll the gateways and/or intervals at which to poll the sensors to avoid data packet collisions.

## Description

This application claims the benefit of priority of U.S. Application Number 63/721,092 filed November 15, 2024.

### TECHNICAL FIELD

The present disclosure relates generally to thermal management and monitoring systems, and more particularly, to dynamic multi-gateway coordination in high-density sensor systems.

### BACKGROUND

Data centers house high performance electronic equipment that must be thermally protected to ensure proper and efficient operation. Thermal protection is typically achieved using complex cooling systems that must be carefully monitored. As data centers scale up, there is a need for software for executing critical tasks such as monitoring and managing thermal conditions, auto-discovering devices, optimizing energy use, etc. In use, traditional thermal management systems aggregate data from connected devices to ensure optimal thermal conditions and performance.

Data centers may utilize sensor networks to gather information throughout the environment. Traditional sensor networks include a plurality of sensors in communication with a base station or gateway. In use, each sensor is positioned to gather environmental data and report the same to the gateway for further handling. As data centers scale up, so does the number of sensors needed to monitor the environment. For example, large scale data centers may require hundreds of sensors to sufficiently monitor the environment.

There are practical limitations on the number of sensors that can be communicatively coupled to a single gateway. As such, expansive sensor networks may require multiple gateways to handle the vast amount of sensor data. As each gateway reports to a management system, contemporaneous polling may result in data packet collisions and consequently critical data being lost.

Therefore, to ensure that critical data is received, what is needed is a dynamic scheme for coordinating gateway polling in a high-density sensor network.

### SUMMARY

According to one aspect, the present disclosure is directed to a system for monitoring environmental conditions in a data center. In embodiments, the system includes a first subset of sensors positioned to monitor environmental conditions in a first coverage area in a data center, a second subset of sensors positioned to monitor environmental conditions in a second coverage area in the data center, a first gateway in communication with the first subset of sensors, the first gateway configured to receive data from the first subset of sensors, a second gateway in communication with the second subset of sensors, the second gateway configured to receive data from the second subset of sensors, and a controller in communication with the first and second gateways, the controller including processing circuitry configured to implement a dynamic polling scheme to coordinate polling of the first and second gateways.

In some embodiments, the dynamic polling scheme, implemented by the controller, includes scheduling a first recurring timeslot at which to poll the first gateway and a second recurring timeslot at which to poll the second gateway, wherein the first and second recurring timeslots are non-overlapping.

In some embodiments, the first and second recurring timeslots are based on a predetermined hierarchy of the first and second coverage areas.

In some embodiments, the first and second recurring timeslots are based on a number of sensors of the respective first and second subsets of sensors.

In some embodiments, the dynamic polling scheme, implemented by the controller, includes assigning, by the controller via the first gateway, a polling interval for each sensor in the first subset of sensors, and assigning, by the controller via the second gateway, a polling interval for each sensor in the second subset of sensors.

In some embodiments, the system further includes at least one additional subset of sensors positioned to monitor environmental conditions in at least one additional coverage area in the data center, and at least one additional gateway in communication with the at least one additional subset of sensors, the at least one additional gateway configured to receive data from the at least one additional subset of sensors, wherein the controller is in communication with the at least one additional gateway, and wherein the dynamic polling scheme, implemented by the controller, further comprises scheduling at least one additional recurring timeslot at which to poll the at least one additional gateway, wherein the at least one additional recurring timeslot does not overlap the first and second recurring timeslots.

In some embodiments, the first and second coverages areas are separate or at least partially overlap.

In some embodiments, the controller is in communication with a thermal management system or is a component of a thermal management system.

According to another aspect, the present disclosure is directed to a data center including an environment including a first thermally controlled area and a second thermally controlled area, a first subset of sensors positioned in the data center to monitor thermal conditions in the first thermally controlled area, a second subset of sensors positioned in the data center to monitor thermal conditions in the second thermally controlled area, a first gateway in communication with the first subset of sensors, the first gateway configured to receive data from the first subset of sensors, a second gateway in communication with the second subset of sensors, the second gateway configured to receive data from the second subset of sensors, and a controller in communication with the first and second gateways, the controller including processing circuitry configured to implement a dynamic polling scheme to coordinate polling of the first and second gateways.

According to a further aspect, the present disclosure is directed to a method for polling gateways in a multi-gateway sensor network. In embodiments, the method includes providing a first subset of sensors positioned to monitor environmental conditions in a first coverage area, providing a second subset of sensors positioned to monitor environmental conditions in a second coverage area, providing a first gateway in communication with the first subset of sensors, the first gateway configured to receive data from the first subset of sensors, providing a second gateway in communication with the second subset of sensors, the second gateway configured to receive data from the second subset of sensors, and providing a controller in communication with the first and second gateways, the controller including processing circuitry configured to implement a dynamic polling scheme to coordinate polling of the first and second gateways.

This summary is provided solely as an introduction to subject matter that is fully described in the following detailed description and drawing figures. This summary should not be considered to describe essential features nor be used to determine the scope of the claims. Moreover, it is to be understood that both the foregoing summary and the following detailed description are explanatory only and are not necessarily restrictive of the subject matter claimed.

### BRIEF DESCRIPTION OF THE DRAWINGS

Implementations of the present disclosure disclosed herein may be better understood when consideration is given to the following detailed description thereof. Such description refers to the included drawings, which are not necessarily to scale, and in which some features may be exaggerated, and some features may be omitted or may be represented schematically in the interest of clarity. Like reference numerals in the drawings may represent and refer to the same or similar element, feature, or function. In the drawings:
FIG. 1A is a schematic illustration of a data center including a first subset or sensors of a high-density sensor network, in accordance with an example embodiment of the present disclosure;
FIG. 1B is a schematic illustration of the data center including a second subset of sensors of the high-density sensor network, in accordance with an example embodiment of the present disclosure;
FIG. 1C is a schematic illustration of the data center including a third subset of sensors of the high-density sensor network, in accordance with an example embodiment of the present disclosure;
FIG. 2 is a schematic illustration of a polling scheme for coordinating polling of a plurality of gateways in a high-density sensor network; and
FIG. 3 is a flow diagram illustrating a methodology for coordinating polling of a plurality of gateways in a high-density sensor network.

### DETAILED DESCRIPTION

Before explaining one or more embodiments of the disclosure in detail, it is to be understood that the embodiments are not limited in their application to the details of construction and the arrangement of the components or steps or methodologies set forth in the following description or illustrated in the drawings. In the following detailed description of embodiments, numerous specific details may be set forth in order to provide a more thorough understanding of the disclosure. However, it will be apparent to one of ordinary skill in the art having the benefit of the instant disclosure that the embodiments disclosed herein may be practiced without some of these specific details. In other instances, well-known features may not be described in detail to avoid unnecessarily complicating the instant disclosure.

As used herein a letter following a reference numeral is intended to reference an embodiment of the feature or element that may be similar, but not necessarily identical, to a previously described element or feature bearing the same reference numeral (e.g., 1, 1a, 1b). Such shorthand notations are used for purposes of convenience only and should not be construed to limit the disclosure in any way unless expressly stated to the contrary.

Further, unless expressly stated to the contrary, "or" refers to an inclusive or and not to an exclusive or. For example, a condition A or B is satisfied by any one of the following: A is true (or present), and B is false (or not present), A is false (or not present) and B is true (or present), and both A and B are true (or present).

In addition, the use of "a" or "an" may be employed to describe elements and components of embodiments disclosed herein. This is done merely for convenience and "a" and "an" are intended to include "one" or "at least one," and the singular also includes the plural unless it is obvious that it is meant otherwise.

Finally, as used herein any reference to "one embodiment" or "embodiments" means that a particular element, feature, structure, or characteristic described in connection with the embodiment is included in at least one embodiment disclosed herein. The appearances of the phrase "in embodiments" in various places in the specification are not necessarily all referring to the same embodiment, and embodiments may include one or more of the features expressly described or inherently present herein, or any combination or sub-combination of two or more such features, along with any other features which may not necessarily be expressly described or inherently present in the instant disclosure.

Broadly, the present disclosure is directed to data centers, cooling system applications, thermal management systems, and sensor networks. More particularly, the present disclosure is directed to systems and methods for coordinating at least one of gateway and sensor polling in high-density sensor networks, for instance wireless sensor networks employed to monitor environmental conditions in a data center. Advantages of the systems and methods disclosed herein include, but are not limited to, minimizing or avoiding the loss of critical data, integration with thermal management systems, enhanced control, scalability, and energy and cost savings.

In embodiments, the described systems are designed to monitor environmental conditions within a data center through a distributed network of sensors and intelligent coordination mechanisms. In embodiments, the system includes at least two subsets of environmental sensors, each responsible for monitoring distinct coverage areas within the data center, for instance temperature, humidity, airflow, or other critical conditions. These subsets are connected to separate gateways, wherein a first subset communicates with a first gateway, a second subset communicated with a second gateway, etc. Each gateway is configured to receive and relay sensor data from its respective coverage area. A central controller is in communication with the respective gateways and contains processing circuitry configured to implement a dynamic polling scheme. In use, the dynamic polling scheme intelligently coordinates when and how frequently data is collected for each gateway, allowing for adaptive, efficient, and scalable monitoring. By dynamically adjusting polling data based on conditions or system demands, the controller helps optimize performance, minimize latency, and reduce unnecessary traffic within the data center's environmental monitoring infrastructure.

In embodiments, sensor networks according to the present disclosure generally include a plurality of sensors, a plurality of gateways in communication with the plurality of sensors, and a controller in communication with at least the plurality of gateways. Each sensor is generally configured to monitor at least one environmental parameter (e.g., temperature, humidity, etc.). Sensors may be grouped according to subsets, for example, with each subset assigned to a predetermined coverage area. Sensors may be wired or wireless. In the case of wireless sensors, communications may be established via conventional protocols such Wi-Fi (e.g., 802.11 family of wireless networking protocols), Bluetooth, Zigbee, Z-Wave, CDMA, TDMA, infrared, etc.

In embodiments, each gateway may communicate with its associated subset of sensors according to a polling scheme in which the gateway is configured to poll the sensors according to a predetermined recurring sequence to obtain data collected by the sensors. In embodiments, a controller in communication with or part of a thermal management system may communicate with multiple gateways via a polling scheme in which the controller is configured to poll the gateways according to a predetermined recurring sequence to obtain data collected by the gateways. In this configuration, data transfer between communicatively coupled devices can be scheduled such that data, for example in the form of packets of information, does not arrive from separate gateways at random time intervals which may result in contemporaneous receipt (e.g., data collisions in which more than one packet is received at the same time or when one packet arrives before another packet has been completely received).

In embodiments, a controller as described herein may include one or more processors and a memory device, or memory. For example, the one or more processors may be configured to execute a set of program instructions maintained in the memory device. The one or more processors may include any processor or processing element known in the art. For the purposes of the present disclosure, the term "processor" or "processing element" may be broadly defined to encompass any device having one or more processing or logic elements (e.g., one or more micro-processor devices, one or more application specific integrated circuit (ASIC) devices, one or more field programmable gate arrays (FPGAs), or one or more digital signal processors (DSPs)). In this sense, the one or more processors may include any device configured to execute algorithms and/or instructions (e.g., program instructions stored in memory). Moreover, different subsystems of the present disclosure may include a processor or logic elements suitable for carrying out at least a portion of the steps described herein. Further, the steps described herein may be carried out by a single controller or, alternatively, multiple controllers. Further, the controller may analyze or otherwise process data received from the sensors and feed the data to additional components or external to the system.

The memory device may include any storage medium known in the art suitable for storing program instructions executable by the associated one or more processors. For example, the memory device may include a non-transitory memory medium. As an additional example, the memory device may include, but is not limited to, a read-only memory, a random-access memory, a magnetic or optical memory device (e.g., disk), a magnetic tape, a solid-state drive and the like. It is further noted that the memory device may be housed in a common controller housing with the one or more processors.

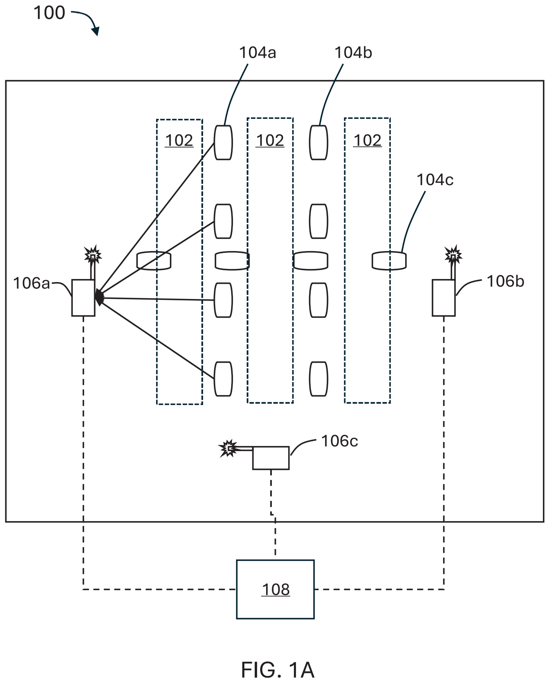

FIGS. 1A-C schematically illustrate a non-limiting example of a data center 100 including electronic equipment mounted in, for example, racks 102. The data center may include one or more of liquid and air-cooling systems for room cooling, in-row cooling, rack cooling, etc. The data center 100 further includes a sensor network, for instance a wireless sensor network, including a plurality of sensors 104a-104c distributed throughout the environment to be monitored. In use, each sensor 104a-104c is configured to detect an environmental parameter (e.g., temperature, humidity, etc.), collect data, and convey the collected data to at least one gateway 106a-106c in communication with at least one controller that is part or in communication with a thermal management system 108.

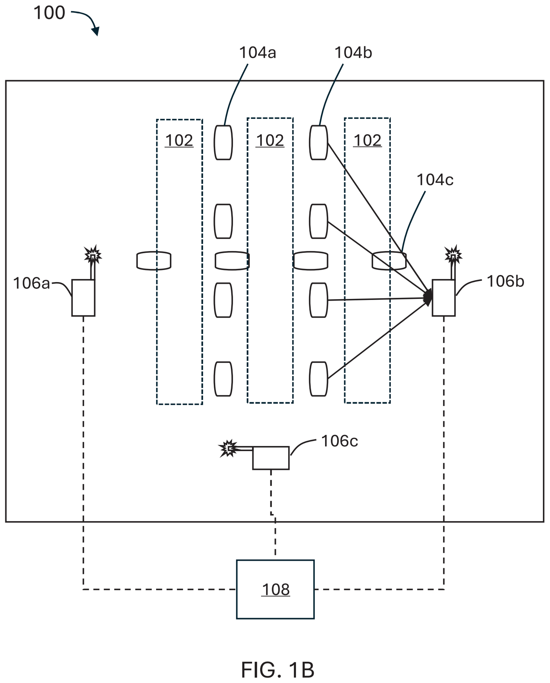

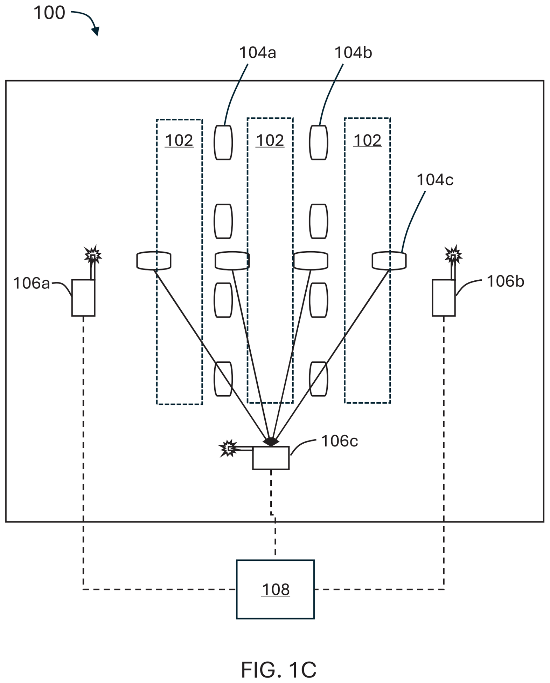

FIG. 1A illustrates a first subset of sensors 104a positioned to monitor a first coverage area and in communication with a first gateway 106a. FIG. 1B illustrates a second subset of sensors 104b positioned to monitor a second coverage area and in communication with a second gateway 106b. FIG. 1C illustrates a third subset of sensors 104c positioned to monitor a third coverage area and in communication with a third gateway 106c. In embodiments, additional sensors grouped to form additional subsets of sensors may be in communication with additional gateways each in communication with the thermal management system 108.

Each sensor 104a-104c and gateway 106a-106c may be wireless-equipped to communicate with at least one other sensor and at least one other gateway within the network. Each sensor 104a-104c may be positioned to monitor the environment or equipment positioned in the environment, such as electronic equipment or cooling system equipment). Each gateway 106a-106c may be positioned in the data center or in a remote location depending on the communication capabilities of the sensors and gateways. The thermal management system 108 may be located on-site in the data center 100 or remote. In embodiments, the thermal management system 108 may include hardware and software capabilities configured to monitor, alert, implement changes, recognize devices, program, etc. In other words, the thermal management system 108 may be a comprehensive cooling system management system.

Each subset of sensors 104a-104c and their respective gateway 106a-106c may include any number of sensors and topology. For example, the topology may include a configuration in which the gateway 106a-106c is configured to send and receive wireless signals to each of the sensors 104a-104c in its respective subset, or a topology in which the sensors 104a-104c may be further configured to communicate with each other to forward data depending on the transmission range and location of the sensors 104a-104c. For example, a sensor 104a-104c positioned at a distance from its respective gateway 106a-106c may relay data to another sensor 104a-104c within range of the respective gateway 106a-106c. In this configuration, relay capabilities can be used to expand the coverage area. In some embodiments, at least one sensor 104a-104c within a particular subset may communicate with more than one gateway 106a-106c. For example, at least one sensor 104a-104c associated with a critical coverage area and/or equipment may communicate with at least two gateways 106a-106c to increase the polling frequency and/or for redundancy.

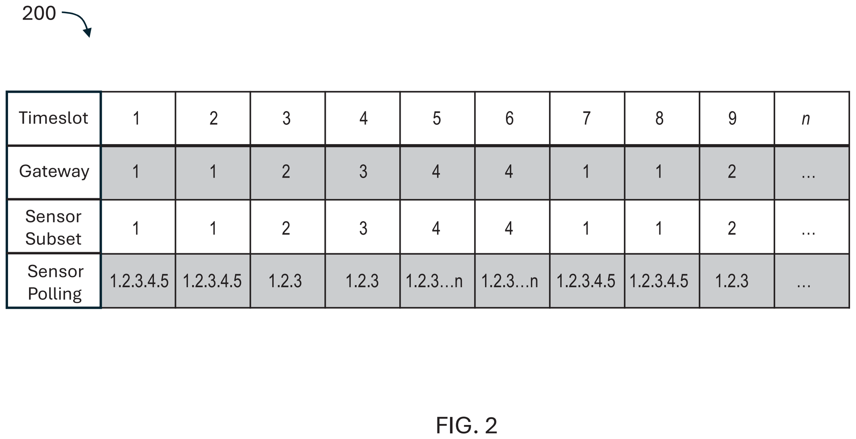

FIG. 2 illustrates a non-limiting example of a polling scheme 200 according to the present disclosure. In embodiments, each gateway 106a-106c may be configured to poll the sensors 104a-104c in its assigned subset of sensors 104a-104c according to a predetermined polling protocol. In embodiments, the polling protocol may be predetermined and programmable via an interface of the thermal management system 108. In embodiments, the polling protocol is time-based wherein each sensor 104a-104c is assigned a time interval, which may or may not be consistent in length depending on at least one of the capabilities of the sensor, latency, environmental parameter to be monitored, sensor hierarchy, etc. Each sensor 104a-b may be assigned a predetermined time interval to be polled, and the time intervals may be organized to form a polling schedule. For example, in the case of the four sensors 104a-104c shown in FIGS. 1A-C included in each subset, four time intervals may be assigned wherein the gateway 106a-106c pings each sensor 104a-104c according to a predetermined schedule such that each sensor 104a-104c transmits its collected data during that time internal. The schedule may include any recurring order depending on the hierarchy (e.g., importance) of the particular sensor and/or coverage area.

Each gateway 106a-106c is configured to poll a particular sensor 104a-104c according to the predetermined recurring schedule. When polled, each sensor 104a-104c transmits collected data to the respective gateway 106a-106c. The collected data may include, but is not limited to, environmental parameter data, alarm data, sensor performance data, battery power data, etc. In the case of alarm data, each sensor 104a-104c may be configured to transmit data to the gateway 106a-106c outside of the assigned polling schedule to reduce latency of the reporting.

Each gateway 106a-106c is likewise assigned a time interval according to a polling schedule. For example, the first gateway 106a in communication with the first subset of sensors 104a may be assigned a first polling interval, the second gateway 106b in communication with the second subset of sensors 104b may be assigned a second polling interval, and the third gateway 106c in communication with the third subset of sensors 106c may be assigned a third time interval. The time intervals may be consistent or may vary according to a hierarchy. For example, a gateway in communication with a large number of sensors may be assigned a time interval longer in duration that a gateway in communication with a small number of sensors. Time intervals may also vary depending on disposition, latency, importance, etc.

In some embodiments, the schedule may be dynamic in terms of assigning time intervals, scheduling time slots, modifications thereto, etc. In that regard, a particular gateway may be assigned to one or more timeslots in the schedule according to a hierarchy, and time slots may be added and adjusted as the wireless sensor system is scaled up and scaled down in terms of the number of gateways, number of sensors, etc.

In use, each gateway 106a-106c is configured to poll its respective subset of sensors 104a-104c according to the predetermined sensor polling schedule, and the controller of the thermal management system 108 is configured to poll each gateway 106a-106c according to the predetermined gateway polling schedule, thereby providing a dynamic polling scheme. In embodiments, the dynamic polling scheme may be programmable in terms of assigned time intervals, scheduled timeslots, hourly schedules, daily schedules, peak energy use times, etc. In embodiments, the controller of the thermal management system 108 may be configured to poll any gateway 106a-106c on demand, for instance in response to receipt of alarm data.

In embodiments, polling may include paging a gateway 106a-106c thereby causing the gateway 106a-106c to send collected data or causing the subset sensors 104a-104c to send collected data via the respective gateway 106a-106c. In that regard, the gateways 106a-106c may function as data collectors including a memory for storing data, or a relay between the sensors 104a-104c and the controller of the thermal management system 108. As mentioned above, collected data may include, but is not limited to, environmental data and sensor performance data. Data may take the form of binary or other data types.

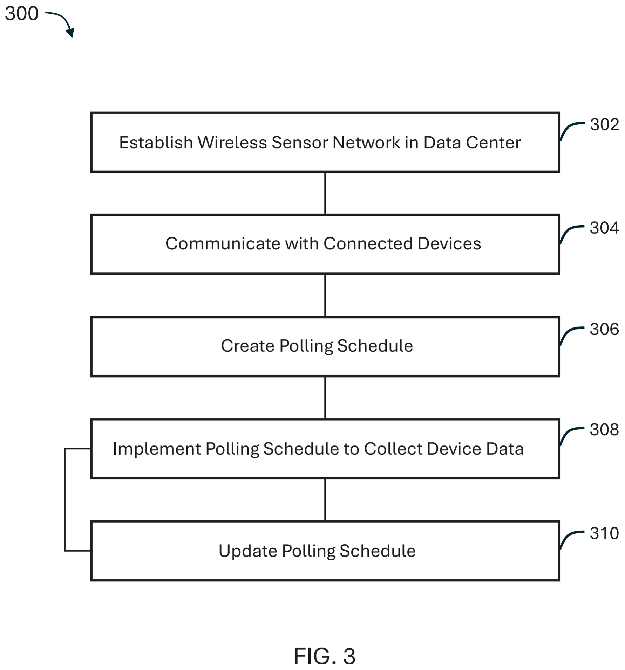

FIG. 3 illustrates a method 300 for establishing and implementing a polling scheme according to the present disclosure. In a step 302, a sensor network is established and implemented in an environment, for instance a data center. In a step 304, a controller in communication with a thermal management system recognizes gateways in the sensor network in communication with subsets of sensors each assigned to a predetermined coverage area. In a step 306, based on the monitoring needs of the environment, scale of the monitoring system, gateway/sensor hierarchy, etc., the controller 308 is used to assign a time interval to each gateway in the network, wherein each time interval corresponds to a timeslot in a schedule. In a step 308, the controller polls the respective gateways according to the schedule to cause the gateways to return collected data, for instance data pertaining to the environment, sensor performance, etc. In a step 310, in response to gateways and sensors moving into and out of the network, environment changes, etc., the schedule may be modified as necessary.

From the above description, it is clear that the present disclosure disclosed herein is well adapted to achieve the objectives and to attain the advantages mentioned herein as well as those inherent in the present disclosure disclosed herein. While exemplary embodiments of the present disclosure disclosed herein have been described for purposes of this disclosure, it will be understood that numerous changes may be made which will readily suggest themselves to those skilled in the art and which are accomplished within the broad scope and coverage of the present disclosure disclosed and claimed herein.

## Claims

1. A system for monitoring environmental conditions in a data center (100), the system comprising:
a first subset of sensors (104a) configured to monitor environmental conditions in a first coverage area in a data center;
a second subset of sensors (104b) configured to monitor environmental conditions in a second coverage area in the data center;
a first gateway (106a) in communication with the first subset of sensors, the first gateway configured to receive data from the first subset of sensors;
a second gateway (106b) in communication with the second subset of sensors, the second gateway configured to receive data from the second subset of sensors; and
a controller in communication with the first and second gateways, the controller including processing circuitry configured to implement a dynamic polling scheme (200) to coordinate polling of the first and second gateways.

2. The system of claim 1, wherein the dynamic polling scheme, implemented by the controller, comprises scheduling a first recurring timeslot at which to poll the first gateway and a second recurring timeslot at which to poll the second gateway, wherein the first and second recurring timeslots are non-overlapping.

3. The system of claim 2, wherein the first and second recurring timeslots are based on a predetermined hierarchy of the first and second coverage areas, and/or,
wherein the first and second recurring timeslots are based on a number of sensors of the respective first and second subsets of sensors.

4. The system of any preceding claim, wherein the dynamic polling scheme, implemented by the controller, comprises:
assigning, by the controller via the first gateway, a polling interval for each sensor in the first subset of sensors; and
assigning, by the controller via the second gateway, a polling interval for each sensor in the second subset of sensors.

5. The system of any preceding claim, further comprising:
at least one additional subset of sensors configured to monitor environmental conditions in at least one additional coverage area in the data center; and
at least one additional gateway in communication with the at least one additional subset of sensors, the at least one additional gateway configured to receive data from the at least one additional subset of sensors,
wherein the controller is in communication with the at least one additional gateway, and
wherein the dynamic polling scheme, implemented by the controller, further comprises scheduling at least one additional recurring timeslot at which to poll the at least one additional gateway, wherein the at least one additional recurring timeslot does not overlap the first and second recurring timeslots.

6. The system of any preceding claim, wherein the first and second coverages areas at least partially overlap, and/or,
wherein the controller is in communication with at least one of a thermal management system (108) or is a component of a thermal management system.

7. A data center (100), comprising:
an environment including a first thermally controlled area and a second thermally controlled area;
a first subset of sensors (104a) positioned in the data center to monitor thermal conditions in the first thermally controlled area;
a second subset of sensors (104b) positioned in the data center to monitor thermal conditions in the second thermally controlled area;
a first gateway (106a) in communication with the first subset of sensors, the first gateway configured to receive data from the first subset of sensors;
a second gateway (106b) in communication with the second subset of sensors, the second gateway configured to receive data from the second subset of sensors; and
a controller in communication with the first and second gateways, the controller including processing circuitry configured to implement a dynamic polling scheme (200) to coordinate polling of the first and second gateways.

8. The data center of claim 7, wherein the dynamic polling scheme, implemented by the controller, comprises scheduling a first recurring timeslot at which to poll the first gateway and a second recurring timeslot at which to poll the second gateway, wherein the first and second recurring timeslots are non-overlapping.

9. The data center of claim 8, wherein the first and second recurring timeslots are based on a predetermined hierarchy of the first and second thermally controlled areas, and/or,
wherein the first and second recurring timeslots are based on a number of sensors of the respective first and second subsets of sensors.

10. The data center of any of claims 7 to 9, wherein the dynamic polling scheme, implemented by the controller, comprises:
assigning, by the controller via the first gateway, a polling interval for each sensor in the first subset of sensors; and
assigning, by the controller via the second gateway, a polling interval for each sensor in the second subset of sensors.

11. The data center of any of claims 7 to 10, wherein the first and second thermally controlled areas at least partially overlap, and/or
further comprising:
at least one additional subset of sensors configured to monitor thermal conditions in at least one additional thermally controlled area in the data center; and
at least one additional gateway in communication with the at least one additional subset of sensors, the at least one additional gateway configured to receive data from the at least one additional subset of sensors,
wherein the controller is in communication with the at least one additional gateway, and
wherein the dynamic polling scheme, implemented by the controller, further comprises scheduling at least one additional recurring timeslot at which to poll the at least one additional gateway, wherein the at least one additional recurring timeslot does not overlap the first and second recurring timeslots.

12. A method for polling gateways in a multi-gateway sensor network, the method comprising:
providing a first subset of sensors (104a) configured to monitor environmental conditions in a first coverage area;
providing a second subset of sensors (104b) configured to monitor environmental conditions in a second coverage area;
providing a first gateway (106a) in communication with the first subset of sensors, the first gateway configured to receive data from the first subset of sensors;
providing a second gateway (106b) in communication with the second subset of sensors, the second gateway configured to receive data from the second subset of sensors; and
providing a controller in communication with the first and second gateways, the controller including processing circuitry configured to implement a dynamic polling scheme (200) to coordinate polling of the first and second gateways.

13. The method of claim 12, wherein the dynamic polling scheme, implemented by the controller, comprises scheduling a first recurring timeslot at which to poll the first gateway and a second recurring timeslot at which to poll the second gateway, wherein the first and second recurring timeslots are non-overlapping.

14. The method of claim 12 or 13, wherein the first and second recurring timeslots are based on at least one of a predetermined hierarchy of the first and second coverage areas, and a number of sensors of the respective first and second subsets of sensors, and/or,
wherein the dynamic polling scheme, implemented by the controller, comprises:
assigning, by the controller via the first gateway, a polling interval for each sensor in the first subset of sensors; and
assigning, by the controller via the second gateway, a polling interval for each sensor in the second subset of sensors.

15. The method of any of claims 12 to 14, further comprising:
providing at least one additional subset of sensors configured to monitor environmental conditions in at least one additional coverage area in the data center; and
providing at least one additional gateway in communication with the at least one additional subset of sensors, the at least one additional gateway configured to receive data from the at least one additional subset of sensors,
wherein the controller is in communication with the at least one additional gateway, and
wherein the dynamic polling scheme, implemented by the controller, further comprises scheduling at least one additional recurring timeslot at which to poll the at least one additional gateway, wherein the at least one additional recurring timeslot does not overlap the first and second recurring timeslots.
